# EUROPEAN PATENT SPECIFICATION

(11) **EP 2 828 883 B1**
(45) Date of publication and mention of the grant of the patent: **31.07.2019**
(21) Application number: 13764357.3
(22) Date of filing: 06.03.2013
(51) Int. Cl.: H01L 21/02, H01L 21/205, H01L 21/20, H01L 21/67, H01L 21/683

(54) **LAMINATE BODY AND METHOD OF MAKING THE SAME FOR TEMPORARY SUBSTRATE SUPPORT**
SCHICHTKÖRPER UND VERFAHREN ZUR HERSTELLUNG DES SCHICHTKÖRPERS FÜR ZEITWEISES STÜTZEN EINES SUBSTRATS
CORPS STRATIFIÉ ET PROCÉDÉ DE FABRICATION DUDIT CORPS STRATIFIÉ POUR SUPPORT TEMPORAIRE DE SUBSTRAT

(30) Priority: 20.03.2012 US 201261613062 P
(43) Date of publication of application: 28.01.2015
(73) Proprietor: 3M Innovative Properties Company, St. Paul, MN 55133-3427 (US)
(72) Inventor: DRONEN, Blake R., Saint Paul, Minnesota 55133-3427 (US); MAHONEY, Wayne S., Saint Paul, Minnesota 55133-3427 (US); LARSON, Eric G., Saint Paul, Minnesota 55133-3427 (US)
(74) Representative: Herzog, Fiesser & Partner Patentanwälte PartG mbB
(86) International application number: PCT/US2013/029314
(87) International publication number: WO 2013/142054

(56) References cited:
- JP-A- 2004 253 483
- JP-A- 2011 238 815
- KR-A- 20090 031 562
- KR-A- 20100 083 359
- KR-A- 20100 121 687
- US-A1- 2008 296 763
- US-A1- 2009 017 248
- US-A1- 2011 223 743
- US-A1- 2012 003 470

## Description

### Field

The present disclosure relates to temporary substrate support during processing.

### Background

In various fields, it can be of interest to process fragile, valuable, or hard-to-handle substrates such as, for example, glasses, films, or semiconductor wafers. For example, in the electronics industry, it can be important to hold substrates, such as glass or semiconductor wafers, for further processing such as vacuum deposition, lamination, grinding or other desirable processing. Typically, such substrates can be held by forming a laminate with a support or support. After the desired processing, it can be important to be able to remove the substrate from the support without causing damage to the substrate.

For example, in the semiconductor industry, efforts to further reduce the thickness of a semiconductor wafer are in progress to respond to the goal of reducing the thickness of semiconductor packages as well as for high-density fabrication by chip lamination technology. Thickness reduction is performed by so-called back side grinding of a semiconductor wafer on the surface opposite that containing pattern-formed circuitry. Usually, in conventional techniques of grinding the back side, or surface, of a wafer and conveying it while holding the wafer with only a backgrinding protective tape, thickness reduction can be accomplished in practice only to a thickness of about 150 micrometers (µm) because of problems such as uneven thickness of the ground wafer or warping of the wafer with protective tape after grinding. For example, Japanese Unexamined Patent Publication (Kokai) No. 6-302569 discloses a method where a wafer is held on a ring-form frame through a pressure-sensitive acrylate adhesive tape, the back surface of this wafer held on the frame is ground and the wafer is conveyed to the next step. However, this method has not yet attained a remarkable improvement over the present level of wafer thickness that may be obtained without encountering the aforementioned problems of unevenness or warping.

U. S. Pat. No. 7,534,498 (Noda et al.) discloses a laminate body for holding a substrate to be ground, such as a silicon wafer, fixed on a support that can be easily separated from the support. The laminate body includes a photothermal conversion layer comprising a light absorbing agent and a heat decomposable resin. After grinding the substrate surface which is opposite that in contact with the joining layer, the laminate body can be irradiated by shining a rastered laser beam through the light transmitting layer to decompose the photothermal conversion layer and to separate the substrate and the light transmitting support.

US 2009/0017248 A1 discloses a layered body including a substrate, a joining layer having a curable acrylate polymer and a curable acrylate adhesion modifying agent in contact with the substrate, a photothermal conversion layer having a light absorbing agent and a heat decomposable resin, and a light transmitting support. Two layers, each comprising an adhesion modifying agent but in different amounts are not disclosed.

### Summary

Thus, there is a need for methods and materials for temporary support of substrates during processing such as, for example, plating, sputtering, or vapor depositing on glass substrates or grinding the backside of silicon wafers that are economical and user friendly. There is a need for forming laminated bodies with substrates when they are processed and then being able to remove the processed substrates from the temporary support without needing to irradiate the sample.

The invention provides a laminate body in accordance with claims 1 and 4 and methods of making a laminate body in accordance with claims 6 and 9. Preferred embodiments are defined in the dependent claims.

In some embodiments, the support can be light-transmitting. In other embodiments, the support can include a support that is a light-blocking substrate. Light-blocking substrates are opaque or semi-opaque and substantially block the transmission of visible radiation. In some embodiments, the light-blocking substrates can transmit light of selected visible wavelengths while substantially blocking the transmission of other visible wavelengths and thus they appear colored. Examples of light-blocking substrates can include metals, alloys, ceramics, and semiconductors.

The release layer can include a polymer made from the polymerization of at least one monomer having free-radical reactive groups such as an alkyl (meth)acrylate. In some embodiments, the release layer can include an adhesion modifying group that can be, in some embodiments, a silicone (meth)acrylate. There is an amount of adhesion-modifying agent in the joining layer. The amount of adhesion-modifying agent in the release layer is greater than the amount of adhesion-modifying agent in the joining layer. The provided laminate body can include a substrate to be held for further processing.

A method of holding a substrate for further processing is also disclosed that includes providing a temporary, removable, bonding layer on a support, laminating the bonding layer to a substrate to form a laminate, performing at least one further processing step on the laminate, and peeling the substrate from the bonding layer without damaging the substrate. The at least one further processing step can expose the substrate to a temperature of greater than about 200°C.

In the present disclosure:
"actinic radiation" refers to any electromagnetic radiation that can produce photochemical reactions and includes ultraviolet, visible, and infrared radiation;
"disposed upon" refers to two layers that either are in direct contact with one another or in are each in direct contact with an intervening layer that, for example, can modify the surface properties of the two layers;
"light-transmitting support" refers to a material that can allow significant amounts (enough to cause a photochemical reaction) of actinic radiation to be transmitted through it;
"(meth)acrylate" refers to esters based upon either acrylic acid or methacrylic acid;
"thermoplastic" refers to a polymer that reversibly turns liquid when heated and freezes to a very glassy state when cooled;
"thermoset" or "thermosetting" refers to a polymeric material that irreversibly cures; and
"UV-curable" refers to polymerization of monomers or oligomers that is induced by irradiation with ultraviolet (UV) and/or visible light.

The provided laminate body and method of making the same provides for substrate support during operations such as, for example, backside grinding of silicon wafers or vapor deposition upon thin glass substrates. The use of a release layer that includes an amount of adhesion-modifying agent provides support for substrates that have varying chemistries in that it provides a customized layer for removal of the substrate after processing. Furthermore, the provided laminate body can provide differential release of the substrate from the support, which can enable high throughput debonding without imparting unneeded stress on the substrate. This is particularly important when the substrate is very thin and brittle.

The above summary is not intended to describe each disclosed embodiment of every implementation of the present invention. The brief description of the drawings and the detailed description which follows more particularly exemplify illustrative embodiments.

### Brief Description of the Drawings

Fig. 1 is a side-view cross section of an embodiment of a provided laminate.
Fig. 2 is a side-view cross section of another embodiment of a provided laminate.
Figs. 3a and 3b are cross-sectional views showing a vacuum adhesion device useful in making the provided laminates.
Fig. 4 is a schematic view showing how the joining layer is peeled from the wafer.

### Detailed Description

In the following description, reference is made to the accompanying set of drawings that form a part of the description hereof and in which are shown by way of illustration several specific embodiments. It is to be understood that other embodiments are contemplated and may be made without departing from the scope of the present invention. The following detailed description, therefore, is not to be taken in a limiting sense.

Unless otherwise indicated, all numbers expressing feature sizes, amounts, and physical properties used in the specification and claims are to be understood as being modified in all instances by the term "about." Accordingly, unless indicated to the contrary, the numerical parameters set forth in the foregoing specification and attached claims are approximations that can vary depending upon the desired properties sought to be obtained by those skilled in the art utilizing the teachings disclosed herein. The use of numerical ranges by endpoints includes all numbers within that range (e.g. 1 to 5 includes 1, 1.5, 2, 2.75, 3, 3.80, 4, and 5) and any range within that range.

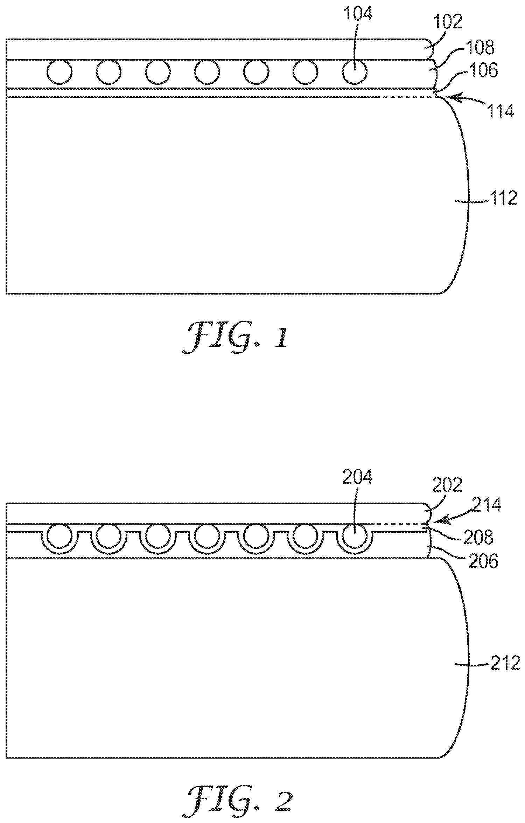

Fig. 1 is a side-view cross-sectional illustration of an embodiment of a provided laminate body 100. Laminate body 100 includes substrate 102 which may include solder balls or bumps 104 if the substrate is a silicon wafer or semiconductor wafer. Joining layer 108 is in contact with release layer 106 and is disposed between release layer 106 and substrate 102. Release layer 106 includes an amount of an adhesion-modifying agent. Joining layer 108 may encapsulate any surface irregularities such as solder bumps 104 as shown in Fig. 1. Release layer 106 is disposed upon support 112. The adhesion of release layer 106 is adjusted by altering the amount of included adhesion-modifying agent so that the laminate separates at separation interface 114 upon application of a peeling force to support 112.

Fig. 2 is a side-view cross-sectional illustration of another embodiment of a provided laminate body 200. Laminate body 200 includes substrate 202 which may include irregularities such as solder balls or bumps 204 if the substrate is a silicon wafer or semiconductor wafer. Release layer 208 is disposed on the circuit side (solder bump side) of wafer 202 and may encapsulate solder bumps 204 as shown in Fig. 2. Joining layer 206 is in contact with release layer 208 and is disposed between release layer 208 and support 212. The adhesion of release layer 208 in this embodiment is adjusted so that the laminate separates at separation interface 214 upon application of a peeling force to support 212.

The laminate body includes a support. The support can be light-transmitting or light-blocking. If light-transmitting, the light-transmitting support can be a material capable of transmitting actinic radiation energy, such as that from a laser or laser diode. The light-transmittance of the support is not limited as long as it does not prevent the transmittance of a practical intensity level of radiation energy into the latent release layer to enable the decomposition of the latent release layer if the latent release layer is light-activated. However, the visible light-transmittance is typically, for example, 50% or more. The light-transmitting support typically has a sufficiently high stiffness and the flexural rigidity of the support is preferably 2×10⁻³ (Pa·m³) or more, more preferably 3×10⁻² (Pa·m³) or more. Examples of useful transparent light-transmitting supports include glass plates and acrylic plates. Transparent light-transmitting supports can also include heat-resistant glass such as borosilicate glass available as PYREX and TENPAX and alkaline earth boro-aluminosilicate glass such as CORNING Eagle XG. The support can also be opaque or transmit less than about 50% of visible radiation. Examples of opaque supports can include semiconductor wafers, ceramics, metals, or light-transmitting supports that transmit only a limited frequency of visible light. In the case of using a UV-joining layer, the support typically transmits ultraviolet radiation.

In one embodiment, the provided laminated bodies have an amount of release layer disposed upon the support. A joining layer is in contact with the release layer. The amount of adhesion-modifying agent in the release layer is adjusted to cause the separation interface to occur between the release layer and the support upon delamination as shown in Fig. 1. The provided joining layer can be substantially inert (unreactive) to organic and inorganic substrate materials and can be stable to relatively high temperatures, for example above 260°C lead free solder reflow conditions. The release layer should have adequate adhesion to both organic and inorganic substrate materials.

In embodiments wherein the provided laminate further comprises a substrate in contact with the release layer, the substrate can be, for example, a brittle material difficult to process by conventional methods. Examples thereof include semiconductor wafers such as silicon and gallium arsenide, a rock crystal wafer, sapphire and glass. The substrate can have surface irregularities. For example, when the substrate is a semiconductor wafer, it can have a circuit side and a backside. The surface side can include circuit elements such as traces, integrated circuits, electronic components, and conductivity connectors such as, for example, solder balls or bumps. Other electrically-connecting devices such as pins, sockets, electrical pads, can also be included on the circuit side.

In some embodiments, the joining layer can be used for fixing the substrate to be processed to the support via the release layer. After the separation of the substrate from the support by delamination, a substrate as well as a support having the joining layer and release layer thereon is obtained. Therefore, the joining layer must be easily separated from the substrate, such as by peeling. Thus, the joining layer has an adhesive strength high enough to fix the substrate to the support via the release layer yet low enough to permit separation from the substrate.

The substrate can have asperities such as circuit patterns or other topographical features on one side. For the joining layer to fill in the asperities of the substrate to be processed the adhesive used for the joining layer is typically in a liquid state during coating and laminating and preferably has a viscosity of less than 10,000 centipoises (cps) at the temperature (for example, 25°C) of the coating and laminating operations. This liquid adhesive is typically coated by a spin coating method among various methods described later. A UV-curable adhesive or a visible light-curable adhesive are typically used which can enable the thickness of the joining layer to be made uniform and moreover, the processing speed to be high for the above-mentioned reason.

The storage modulus of the adhesive can typically be 100 MPa or more at 25°C and 10 MPa or more at 50°C under the use conditions after removal of the solvent of the adhesive in the case of a solvent-type adhesive, after curing in the case of a curable adhesive, or after normal temperature solidification in the case of a hot-melt adhesive. With this elastic modulus, the substrate to be ground can be prevented from warping or distorting due to stress imposed during grinding and can be uniformly ground to an ultrathin substrate. The storage modulus or elastic modulus as used herein can, for example, be measured on an adhesive sample size of 22.7 mm × 10 mm × 50 µm in a tensile mode at a frequency of 1 Hz, a strain of 0.04% and a temperature ramp rate of 5°C/min. This storage modulus can be measured using SOLIDS ANALYZER RSA II (trade name) manufactured by Rheometrics, Inc. The backing must have sufficiently high flexibility so as to permit the separation of the joining layer from the substrate by peeling.

The thickness of the joining layer is not particularly limited as long as it can ensure the thickness uniformity required for the grinding of the substrate to be ground and the tear strength necessary for the peeling of the joining layer from the wafer after removing the support from the laminate body, and can sufficiently absorb the asperities on the substrate surface. The thickness of the joining layer is typically from about 10 µm to about 150 µm, preferably from about 25 µm to about 100 µm. The joining layer may comprise a curable (meth)acrylate polymer with an amount of adhesion-modifying agent. The joining layer can include a curable (meth)acrylate adhesion-modifying agent in an amount greater than about 0.1 % or an amount less than about 6.0 % by weight. In some embodiments, the curable (meth)acrylate adhesion-modifying agent can be a silicone polymer substituted with at least one of (meth)acrylate group(s) or methacrylate group(s). Typically, the curable (meth)acrylate adhesion-modifying agent can be soluble in the curable (meth)acrylate polymer before curing. In addition, the viscosity of the combination of the curable (meth)acrylate adhesion-modifying agent and the curable (meth)acrylate polymer can be less than about 10,000 centipoises at ambient temperature and more preferably less than 5,000 centipoises. For example, the curable (meth)acrylate adhesion-modifying agent may be an (meth)acrylate modified silicone polymer, such as EBECRYL 350 from Cytec Industries (West Paterson, NJ), CN9800 from Sartomer Company (Exton, PA), or TEGO RAD 2250, TEGO RAD 2500, TEGO RAD 2650, or TEGO RAD 2700 available from Evonik Industries (Essen, Germany).

The release layer can include a polymer made from the polymerization of at least one monomer having free-radical reactive groups. In some embodiments, the at least one monomer having free-radical reactive groups can include an alkyl (meth)acrylate. In some embodiments, useful polymers are derived from alkyl (meth)acrylate compositions that can include from about 75 to about 95 parts by weight of an alkyl (meth)acrylate having 1 to 14 carbons in the alkyl group. The alkyl (meth)acrylate can include aliphatic, cycloaliphatic, or aromatic alkyl groups. Useful alkyl (meth)acrylates (i.e., acrylic acid alkyl ester monomers) include linear or branched monofunctional (meth)acrylates or methacrylates of non-tertiary alkyl alcohols, the alkyl groups of which have from 1 up to 14 and, in particular, from 1 up to 12 carbon atoms. Useful monomers include, for example, 2-ethylhexyl (meth)acrylate, ethyl (meth)acrylate, methyl (meth)acrylate, n-propyl (meth)acrylate, isopropyl (meth)acrylate, pentyl (meth)acrylate, n-octyl (meth)acrylate, isooctyl (meth)acrylate, isononyl (meth)acrylate, n-butyl (meth)acrylate, isobutyl (meth)acrylate, hexyl (meth)acrylate, n-nonyl (meth)acrylate, isoamyl (meth)acrylate, n-decyl (meth)acrylate, isodecyl (meth)acrylate, dodecyl (meth)acrylate, isobornyl (meth)acrylate, cyclohexyl (meth)acrylate, phenyl meth(acrylate), benzyl meth(acrylate), and 2-methylbutyl (meth)acrylate, and combinations thereof.

Other useful free-radical reactive groups can include copolymerizable polar monomers such as acrylic monomers containing carboxylic acid, amide, urethane, or urea functional groups. Weak polar monomers like N-vinyl lactams may also be included. A useful N-vinyl lactam is N-vinylcaprolactam. In general, the polar monomer content in the adhesive can include less than about 5 parts by weight or even less than about 3 parts by weight of one or more polar monomers. Polar monomers that are only weakly polar may be incorporated at higher levels, for example 10 parts by weight or less. Useful carboxylic acids include acrylic acid and methacrylic acid. Useful amides include N-vinyl caprolactam, N-vinyl pyrrolidone, (meth)acrylamide, N-methyl (meth)acrylamide, N,N-dimethyl acrylamide, N,N-dimethyl meth(acrylamide), and N-octyl (meth)acrylamide.

The at least one monomer having free-radical reactive groups can include hydroxyl-containing monomers such as 2-hydroxyethyl (meth)acrylate, 3-hydroxypropyl (meth)acrylate, 4-hydroxybutyl (meth)acrylate, 2-hydroxyethylacrylamide, and N-hydroxypropylacrylamide. Hydroxy-functional monomers based on glycols derived from ethylenoxide or propyleneoxide can also be used. Other polymerizable free-radical reactive groups such as vinyl groups can also be included within the scope of this disclosure. Vinyl group-containing monomers can include vinyl halides, vinylidene halides; vinyl ethers such as ethyl vinyl ether, n-butyl vinyl ether, iso-butyl vinyl ether, tert-butyl vinyl ether, cyclohexyl vinyl ether, 2-ethylhexyl vinyl ether, and dodecyl vinyl ether; divinyl ethers such as 1,4-butanediol divinyl ether, diethylene glycol divinyl ether; hydroxy vinyl compounds such as hydroxybutyl vinyl ether and 1,4-cyclohexanedimethanol mono vinyl ether.

The release layer also includes an amount of adhesion-modifying agent. The adhesion-modifying agent can include the same material useful in the joining layer. The release layer has a larger amount of adhesion-modifying agent than the joining layer. When the adhesion-modifying agent is a silicone (meth)acrylate, the silicone (meth)acrylate can be present in the release layer in an amount of up to 0.5% by weight (wt%), up to 1.0 wt%, up to 2.0 wt%, up to 3.0 wt%, or even up to 5.0 wt% of the total amount of release layer. The amount of adhesion-modifying agent in the release layer can be adjusted to make the separation interface, upon delamination of the substrate, occur where desired. For example, in the embodiment illustrated in Fig. 1, the desired location of the separation interface 114 is between the release layer and the support, whereas in the embodiment illustrated in Fig. 2, the desired separation interface 214 is between the release layer and the substrate instead of from the joining layer to the support.

Useful types of silicone (meth)acrylate adhesion-modifying agents can be organic-modified (meth)acrylated silicones having Structure (I): 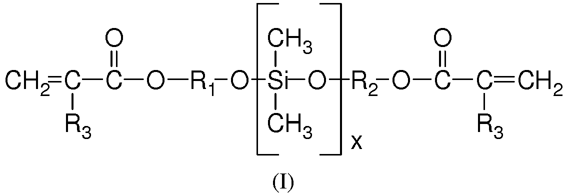 where R₁ and R₂ are hydrocarbon-based radicals such as polyethylene oxide, polypropylene oxide, and polytetramethylene oxide, C₂ - C₁₂ aliphatic radicals, C₂ - C₁₂ cyclic aliphatic radicals, aromatic radicals, and polyester-based radicals, and R₃ is either H or CH₃. Exemplary materials are poly(alkyleneoxide) modified silicone (meth)acrylates like TEGORAD 2250, 2100, 2200, 2300 available from Evonik Industries, Mobile, Alabama and EBECRYL 350 available from Cytec, Woodland Park, N.J, polyester modified silicone (meth)acrylates such as MIRAMER SIP 900 available from Miwon Specialty Chemicals, South Korea, and aromatic epoxy modified silicone (meth)acrylates like ALBIFLEX 712 also available from Evonik Industries. Other suitable (meth)acrylate modified silicone polymers would be linear, di-functional water dispersible (meth)acrylate silicone pre-polymers available under the trade designation SILMER ACR from Siltech Corporation (Toronto, Canada). Examples of these would be SILMER ACR Di-1508, SILMER ACR Di-2510, SILMER ACR Di-1010, SILMER ACR Di-2010, and SILMER ACR Di-4515. Additional suitable (meth)acrylate modified silicone polymers include reactive coating additives such as COATOSIL 3503 and COATOSIL 3509 from Momentive Performance Materials, Albany NY. These modified silicone (meth)acrylates improve compatibility in the joining layer and in the release layer. Improved compatibility generally leads to more effectiveness in preventing premature delamination in any of the process steps of the layered body and still allowing for easy removal during the debonding process. Typical levels of the adhesion-modifying agent are 0.1 - 10 weight % in the joining layer and the release layer. More typically, levels are 0.1 - 4%.

The release layer, the joining layer, or both layers can also include a defoaming agent. The defoaming agent can comprise a perfluoroether monomer. It has been found that the addition of small amounts of such monomers to adhesive compositions such as provided joining layers can prevent bubbling-particularly during vacuum formation of a laminate. The perfluorinated ether monomers can be used in amounts sufficient to selectively reduce the adhesion of the joining layer to the substrate or to the support. In addition, as disclosed in Applicants' co-owned application, US2013/0084459 A1 (Larson et al.), filed September 30, 2011. The monomer is generally used in amounts of at least 0.05 wt% of the curable components and in amounts of no greater than 5 wt% of the adhesive components.

In addition to a curable (meth)acrylate polymer and an amount of an acrylic adhesion-modifying agent, the joining layer can also include, for example, photoinitiators. The adhesive joining layer can include a photoinitiator, for example, in an amount between the range of about 0.5% and about 5% by weight. Useful photoinitiators include those known as useful for photocuring free-radically polyfunctional (meth)acrylates. Exemplary photoinitiators include benzoin and its derivatives such as alpha-methylbenzoin; alpha-phenylbenzoin; alpha-allylbenzoin; alpha-benzylbenzoin; benzoin ethers such as benzil dimethyl ketal (e.g., "IRGACURE 651" from BASF, Florham Park, NJ), benzoin methyl ether, benzoin ethyl ether, benzoin n-butyl ether; acetophenone and its derivatives such as 2-hydroxy-2-methyl-1-phenyl-1-propanone (e.g., "DAROCUR 1173" from BASF) and 1-hydroxycyclohexyl phenyl ketone (e.g., "IRGACURE 184" from BASF); 2-methyl-1-[4-(methylthio)phenyl]-2-(4-morpholinyl)-1-propanone (e.g., "IRGACURE 907" from BASF); 2-benzyl-2-(dimethylamino)-1-[4-(4-morpholinyl)phenyl]-1-butanone (e.g., "IRGACURE 369" from BASF) and phosphinate derivatives such as ethyl-2,4,6-trimethylbenzoylphenylphoshinate (e.g. "TPO-L" from BASF, Florham Park, NJ).

Other useful photoinitiators include, for example, pivaloin ethyl ether, anisoin ethyl ether, anthraquinones (e.g., anthraquinone, 2-ethylanthraquinone, 1-chloroanthraquinone, 1,4-dimethylanthraquinone, 1-methoxyanthraquinone, or benzanthraquinone), halomethyltriazines, benzophenone and its derivatives, iodonium salts and sulfonium salts, titanium complexes such as bis(eta₅-2,4-cyclopentadien-1-yl)-bis[2,6-difluoro-3-(1H-pyrrol-1-yl)phenyl]titanium (e.g., "CGI 784DC" from BASF); halomethyl-nitrobenzenes (e.g., 4-bromomethylnitrobenzene), mono-and bis-acylphosphines (e.g., "IRGACURE 1700", "IRGACURE 1800", "IRGACURE 1850", and "DAROCUR 4265"). Typically, the initiator is used in amounts ranging from 0.1 to 10%, preferably 2 to 4% by weight.

In addition to the curable (meth)acrylate polymer, the curable (meth)acrylate adhesion modifying agent and the photoinitiator, the joining layer can also include, for example, reactive diluents. The adhesive joining layer can include, for example, a reactive diluent in an amount between the range of about 10% and about 70% by weight. Reactive diluents can be used to adjust viscosity and/or physical properties of the cured composition. Examples of suitable reactive diluents include mono- and polyfunctional (meth)acrylate monomers (e.g., ethylene glycol di(meth)acrylate, hexanediol di(meth)acrylate, triethylene glycol di(meth)acrylate, trimethylolpropane tri(meth)acrylate, tripropylene glycol di(meth)acrylate, tetrahydrofurfuryl (meth)acrylate, phenoxyethylacrylate.), vinyl ethers (e.g., butyl vinyl ether), vinyl esters (e.g., vinyl acetate), and styrenic monomers (e.g., styrene).

According to the present invention, the release layer and the joining layer are made from the same adhesive base material.

During the manufacture of the provided laminate body, it can be important to prevent undesirable foreign substances such as air from entering between layers or from being released from any of the layers of the laminate body. To prevent air bubbles, the laminate body may be made in a vacuum apparatus as described below. In the case of manufacturing laminate body 100 shown in Fig. 1, the following method, for example, may be considered. First, the precursor coating solution of release layer 106 can be coated on support 112 by any one of the methods known in the art and, optionally, cured. Joining layer 108 can be coated on substrate 102 on the non-ground side or circuit side. Coated support 112 and coated substrate 102 can then be laminated together to form a provided laminate body. The formation of such a laminate body is typically performed under vacuum to prevent air from entering between layers. This can be attained by, for example, by modifying a vacuum adhesion device such as that described in U. S. Pat. No. 6,221,454 (Kazuta et al.)

The provided laminate body can be used for holding substrates while the substrates are being subjected to a process. Such processes can include, for example, backside grinding, coating, including vacuum coating, vapor deposition, etching, stripping, chemically treating, annealing, polishing, stress relieving, bonding or attaching, optically measuring and electrically testing. The contemplated processes can expose the substrate to a temperature of greater than about 150°C, greater than about 200°C, or even greater than about 300°C.

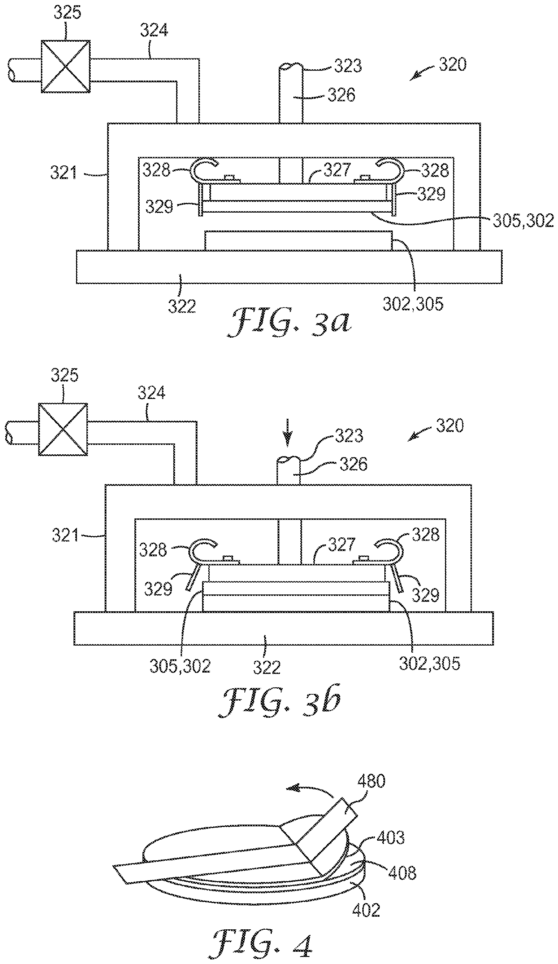

In one aspect, the method of the present disclosure can be described below by referring to the drawings. Figs. 3a and 3b are cross-sectional views of a vacuum adhesion device suitable for the production of the laminate body of one embodiment of the present disclosure. Vacuum adhesion device 320 comprises vacuum chamber 321; supporting part 322 provided in the vacuum chamber 321, on which substrate 302 or support 305 is disposed; and holding/releasing means 323 provided in vacuum chamber 321 and movable in the vertical direction at the upper portion of supporting part 322, which holds the other one of support 305 or substrate 302. Vacuum chamber 321 is connected to pressure reducing device 325 via pipe 324, so that the pressure inside vacuum chamber 321 can be reduced. Holding/releasing means 233 has shaft 326 movable up and down in the vertical direction, contact surface part 327 provided at the distal end of shaft 326, leaf springs 328 provided in the periphery of contact surface part 327, and holding claws 329 extending from each leaf spring 328. As shown in Fig. 3a, when leaf springs 328 are in contact with upper surface of the vacuum chamber 321, leaf springs 328 are compressed and holding claws 329 are directed toward the vertical direction to hold support 305 or wafer 302 at peripheral edges. On the other hand, as shown in Fig. 3b, when shaft 326 is pressed down and support 305 or wafer 302 is in close proximity to wafer 302 or support 305 respectively disposed on the supporting part, holding claws 329 are released together with leaf springs 328 to superimpose support 305 and wafer 302.

Using vacuum adhesion device 320, the provided laminate body can be manufactured as follows. First, as described above, a release layer is provided on support 305. Separately, a substrate to be laminated is prepared. A joining layer is provided on substrate 302. Then, support 305 and wafer 302 are disposed in vacuum chamber 321 of vacuum adhesion device 320 as shown in Fig. 3a, the pressure is reduced by the pressure reducing device, shaft 326 is pressed down to layer or laminate the wafer as shown in Fig. 3b and after opening to air, the adhesive is cured, if desired, to obtain the provided laminate body.

After the substrate is processed, the support can be separated from the substrate. In some embodiments, after separation the substrate has the joining layer and release layer attached to it.
Fig. 4 is a schematic view showing how the joining layer/release layer can be peeled. For the removal of joining/release layer 403, adhesive tape 480 can be used. Adhesive tape 480 can create a stronger adhesive bond with joining/release layer 403 than the adhesive bond between substrate 402 and joining layer 403.

The present disclosure is effective, for example, in the following applications.

### 1. Layered CSP (Chip Scale Package) for High-Density Packaging

The present disclosure is useful, for example, with a device form called system-in-package where a plurality of Large Scale Integrated (LSI) devices and passive parts are housed in a single package to realize multifunction or high performance, and is called a stacked multi-chip package. According to the present disclosure, a wafer of 25 µm or less can be reliably manufactured in a high yield for these devices.

### 2. Through-Type CSP Requiring High Function and High-Speed Processing

In this device, the chips are connected by a through electrode, whereby the wiring length is shortened and the electrical properties are improved. To solve technical problems, such as formation of a through hole for forming a through electrode and embedding of copper in the through hole, the chip may be further reduced in the thickness. In the case of sequentially forming chips having such a configuration by using the layered body of the present disclosure, an insulating film and a bump (electrode) may be formed on the back surface of the wafer and the layered body needs resistance against heat and chemicals.

### 3. Thin Compound Semiconductor (e.g., GaAs) Improved in Heat Radiation Efficiency, Electrical Properties, and Stability

Compound semiconductors such as gallium arsenide are being used for high-performance discrete chips, laser diode and the like because of their advantageous electrical properties (high electron mobility, direct transition-type band structure) over silicon. Using the layered body of the present disclosure and thereby reducing the thickness of the chip increases the heat dissipation efficiency thereof and improves performance. At present, the grinding operation for thickness reduction and the formation of an electrode are performed by joining a semiconductor wafer to a glass substrate as the support using a grease or a resist material. Therefore, the joining material may be dissolved by a solvent for separating the wafer from the glass substrate after the completion of processing. This is accompanied with problems that the separation requires more than several days time and the waste solution should be treated. These problems can be solved when the layered body of the present disclosure is used.

### 4. Application to Large Wafer for Improving Productivity

In the case of a large wafer (for example, a 12 inch-diameter silicon wafer), it is very important to separate the wafer and the support easily. The separation can be easily performed when the layered body of the present disclosure is used, and therefore, the present disclosure can be applied also to this field.

### 5. Thin Rock Crystal Wafer

In the field of rock crystal wafer, the thickness reduction of a wafer is required to increase the oscillation frequency. The separation can be easily performed when the layered body of the present disclosure is used, and therefore, the present disclosure can be applied also to this field.

### 6. Thin Glass for Liquid Crystal Display

In the field of liquid crystal display, the thickness reduction of the glass is desired to reduce the weight of the display and it is desired that the glass be uniform thickness. The separation can be easily performed when the layered body of the present disclosure is used, and therefore, the present disclosure can be applied also to this field.

Objects and advantages of this invention are further illustrated by the following examples, but the particular materials and amounts thereof recited in these examples, as well as other conditions and details, should not be construed to unduly limit this invention.

### Examples

### Test Measurements

### Peel Force Measurements

Peel force measurements, to determine the peel force between a joining or release layer coatings and substrate surfaces were made on an INSIGHT MATERIALS TESTING SYSTEM 30EL, 820.030-EL, having a 30kN capacity available from MTS System Corp., Eden Prairie, Minnesota. A piece of WAFER DE-TAPING TAPE 3305, available from the 3M Company, St. Paul, Minnesota, was laminated to the surface of the joining or release layer coated on a post-processed test substrate. The tape was sized such that about a 75 mm tab of tape extended from the edge of the substrate. Two parallel cuts, about 25 mm apart, were made in the tape and underlying adhesive using a razor blade. The substrate was mounted on a mounting plate, affixed to the tensile tester's base plate fixture. The 75 mm tape tab was then attached to the upper fixture of the tensile testing machine, said fixture connected to the vertical load cell, such that, a 90 degree peel test could be conducted at a rate of 125 mm/min.

**Materials**

| Abbreviation or Trade Name | Description |
|---|---|
| Joining Composition A | A photocurable acrylic adhesive composition LC-5200 (available from 3M) that contains 0.35 weight percent adhesion-modifying agent |
| Release Composition B | A photocurable acrylic adhesive composition LC-5200 (available from 3M) that contains 1.5 weight percent adhesion-modifying agent. |
| Release Composition C | A photocurable acrylic adhesive composition LC-5200 (available from 3M) that contains 1.0 weight percent adhesion modifying agent. |

### Example 1

Approximately 2.5 cm³ of Release Composition B was manually syringe dispensed on a 201 mm diameter x 0.7 mm thick glass support (Eagle XG, available from Corning Inc., Corning, New York, USA) and spun using a spin coater (PWM32-BD-CB15, Headway Research Incorporated, Garland, Texas) at 3000 rpm for 25 seconds achieving a uniform 18 µm thick coating. The coated support was then cured open face, in air, for 5 seconds using a 6 inch (15.2 cm) long Fusion Systems D bulb, 300 watt/inch.

Approximately 7 cm³ of Joining Composition A was manually syringe dispensed on a 200 mm bare silicon wafer substrate (Wafer Reclaim Services, Spring City, PA.). The adhesive was uniformly coated on the wafer via spin coating at 1150 rpm for 20 seconds, resulting in a 48 µm thick coating. The adhesive-coated silicon wafer was bonded, under vacuum, to the Release Composition B-coated surface of the 201 mm diameter x 0.7 mm thick glass support using a wafer support system bonder, model number WSS 8101M (available from Tazmo Co., LTD. Freemont, California). The Joining Composition A was UV cured through the glass support for 20 seconds using a 6 inch (15.2 cm) long Fusion Systems D bulb, 300 watt/inch.

The backside of the silicon wafer was then ground to a thickness of 50 µm, using conventional techniques. No chipping, cracking or other wafer damage was observed. The bonded wafer-support stack was heat aged at 260°C for 10 minutes to replicate customer backside thermal cycling. No delamination of the Si wafer substrate or glass support, or separation of the Joining Composition A layer and the Release Composition B layers was observed.

The bonded stack was bonded to a dicing tape and frame using manual framer model UH114-8 (available from USI Ultron Systems, Inc., Moorpark, CA, USA.). The bonded, framed stack was then placed on a porous vacuum chuck to firmly affix the assembly. Separation of the glass support from the bonded stack was initiated by inserting a razor blade in to the gap defined by the glass support and silicon wafer substrate. A flexible polymeric vacuum plate (avalaible from Suss MicroTek Inc., Sunnyvale, CA, USA) was positioned over the glass support and evacuated to secure the exposed glass surface to the flex plate. The flex plate was manually flexed and lifted to sequentually pry and eventually separate the glass from the release layer surface. The exposed release layer and adhesive joining layer were mechanically peeled as single layer from the Si wafer substrate surface with a conventional de-taping peel method using wafer detaping tape 879 (available from 3M Company, St Paul, MN, USA.) The peel force required to separate Joining Composition A from a bare silicon wafer after heat aging for 10 min at 260°C was previously measured to be approximately 1N/25 mm. There was no visible residue left on the wafer after peel.

### Example 2

Approximately 2.5 cm³ of Release Composition C was manually syringe dispensed on a 200 mm bare silicon wafer substrate (Wafer Reclaim Services, Spring City, PA.) and spun using a spin coater (PWM32-BD-CB15, Headway Research Incorporated, Garland, Texas) at 3000 rpm for 25 seconds achieving a uniform 18 µm thick coating. The coated support was then cured open face, in air, for 5 seconds using a 6 inch (15.2 cm) long Fusion Systems D bulb, 300 watt/inch.

Approximately 7 cm³ of Joining Composition A was dispensed using a manual syringe on top of the 200 mm silicon wafer coated with Release Composition C. The adhesive was uniformly coated on the wafer via spin coating at 760 rpm for 20 seconds, resulting in an approximately 50 µm thick coating. The adhesive-coated silicon wafer was bonded, under vacuum, to a 201 mm diameter x 0.7 mm thick glass support (Eagle XG, available from Corning Inc., Corning, New York, USA) using a wafer support system bonder, model number WSS 8101M (available from Tazmo Co., LTD. Freemont, California). The Joining Composition A was UV-cured through the glass support for 20 seconds using a 6 inch (15.2 cm) long Fusion Systems D bulb, 300 watt/inch.

The backside of the silicon wafer was then ground to a thickness of 50 micron, using conventional techniques. No chipping, cracking or other wafer damage was observed. The bonded wafer-support stack was heat aged at 260°C for 10 minutes to replicate customer backside thermal cycling. No delamination of the Si wafer substrate or glass support, or separation of the Joining Composition A layer and the Release Composition C layer was observed.

The bonded stack was bonded to a dicing tape and frame using manual framer model UH114-8 (available from USI Ultron Systems, Inc., Moorpark, CA, USA.) The bonded, framed stack was then placed on a porous vacuum chuck to firmly affix the assembly. Separation of the silicon wafer substrate from the glass support was initiated by inserting a razor blade in to the gap defined by the glass support and silicon wafer substrate. A flexible polymeric vacuum plate (avalaible from Suss MicroTek Inc., Sunnyvale, CA, USA) was positioned over the glass support and evacuated to secure the exposed glass surface to the flex plate. The flex plate was manually flexed and lifted to sequentually pry and eventually separate the silicon wafer substrate from the release layer surface. There was no visible residue left on the wafer after separation from the support glass. The exposed release layer and adhesive joining layer were manually peeled as single layer sheet from the glass support surface.

### Example 3

Approximately 7 cm³ of Release Composition B was dispensed using a manual syringe onto a 202 mm diameter x 1.0 mm thick glass support (Tempax, available from Mitorika Glass Company, Ltd., Japan). The adhesive was uniformly coated on the glass support via spin coating at 100 rpm for 20 seconds, resulting in an approximately 50 µm thick coating. The release-coated support was bonded, under vacuum, to a 201 mm diameter x 0.7 mm thick glass substrate (Eagle XG, available from Corning Inc., Corning, New York, USA) using a wafer support system bonder, model number WSS 8101M (available from Tazmo Co., LTD. Freemont, California). The Release Composition B was UV cured through the glass support for 20 seconds using a 6 inch (15.2 cm) long Fusion Systems D bulb, 300 watt/inch. The bonded substrate-support stack was heat aged at 250°C for 1 hour to replicate customer backside thermal cycling. No delamination of the glass substrate or support from the Release Composition B was observed.

The bonded stack was then placed on a porous vacuum chuck to firmly affix the assembly. Separation of the glass substrate from the glass support was initiated by inserting a razor blade in to the gap defined by the glass support and glass substrate. A flexible polymeric vacuum plate (avalaible from Suss MicroTek Inc., Sunnyvale, CA, USA) was positioned over the glass substrate and evacuated to secure the exposed glass surface to the flex plate. The flex plate was manually flexed and lifted to sequentually pry and eventually separate the glass substrate from the glass support. The exposed release layer was manually peeled as single layer sheet. There was no visible residue left on the substrate after separation from the support glass.

Various modifications and alterations to this invention will become apparent to those skilled in the art without departing from the scope of this invention. It should be understood that this invention is not intended to be unduly limited by the illustrative embodiments and examples set forth herein and that such examples and embodiments are presented by way of example only with the scope of the invention intended to be limited only by the claims set forth herein as follows.

## Claims

1. A laminate body comprising:
a support (112);
a photocurable acrylic adhesive composition release layer (106) disposed upon and in contact with the support (112);
a photocurable acrylic adhesive composition joining layer (108) disposed upon and in contact with the release layer (106), the photocurable acrylic adhesive composition of the joining layer (108) being the same as that of the release layer (106); and
a substrate (102) disposed upon and in contact with the joining layer (108),
wherein the release layer (106) includes an amount of an adhesion-modifying agent;
wherein the joining layer (108) includes an amount of an adhesion-modifying agent; and
wherein the amount of adhesion-modifying agent in the release layer (106) is greater than the amount of adhesion-modifying agent in the joining layer (108), so as to enable separation of the laminate at the interface between the release layer (106) and the support (112) upon application of a peeling force to the support (112).

2. A laminate body according to claim 1, wherein the release layer comprises a polymer made from the polymerization of at least one monomer having free-radical reactive groups.

3. A laminate body according to claim 1, wherein the amount of adhesion modifying agent is present in the release layer in an amount of from greater than 0 to less than about 6.0 weight percent based upon the total weight of the release layer.

4. A laminate body comprising:
a support (212);
a photocurable acrylic adhesive composition joining layer (206) disposed upon and
in contact with the support (212);
a photocurable acrylic adhesive composition release layer (208) disposed upon and in contact with the joining layer (206); and
a substrate (202) in contact with the release layer (208),
wherein the release layer (208) comprises an amount of an adhesion-modifying agent;
wherein the joining layer (206) includes an amount of an adhesion-modifying agent; and
wherein the amount of adhesion-modifying agent in the release layer (208) is greater than the amount of adhesion-modifying agent in the joining layer (206), so as to enable separation of the laminate at the interface between the release layer (208) and the substrate (202) upon application of a peeling force to the support (212).

5. A laminate body according to claim 1 or 4 wherein the adhesion-modifying agent of the release layer comprises a silicone (meth)acrylate in an amount of up to 2.0 wt.-%, based on the total weight of the release layer.

6. A method of making a laminate body comprising:
coating a photocurable acrylic adhesive composition joining layer (108) on a substrate (102) so as to be in contact with the substrate (102);
coating a photocurable acrylic adhesive composition release layer (106) on a support (112) so as to be in contact with the support (112), wherein the photocurable acrylic adhesive composition of the joining layer (108) is the same as that of the release layer (106); and
laminating the substrate (102) coated with the joining layer (108) to the support (112) coated with the release layer (106),
wherein the release layer (106) includes an amount of an adhesion-modifying agent;
wherein the joining layer (108) includes an amount of an adhesion-modifying agent; and
wherein the amount of adhesion-modifying agent in the release layer (106) is greater than the amount of adhesion-modifying agent in the joining layer (108), so as to enable separation of the laminate at the interface between the release layer (106) and the support (112) upon application of a peeling force to the support (112) .

7. A laminate body according to claim 1 or 4, or a method of making a laminate body according to claim 6, wherein the adhesion-modifying agent of the release layer and of the joining layer comprises a silicone (meth)acrylate.

8. A method of making a laminate body according to claim 6, wherein the method is performed under vacuum.

9. A method of making a laminate body comprising:
coating a photocurable acrylic adhesive composition release layer (208) on a substrate (202) so as to be in contact with the substrate (202);
coating a photocurable acrylic adhesive composition joining layer (206) on the release layer (208) on the substrate (202) so as to be in contact with the release layer (208);
laminating the substrate (202) coated with the release layer (208) and the joining layer (206) to the support(212),
wherein the release layer (208) includes an amount of an adhesion-modifying agent;
wherein the joining layer (206) includes an amount of an adhesion-modifying agent; and
wherein the amount of adhesion-modifying agent in the release layer (208) is greater than the amount of adhesion-modifying agent in the joining layer (206), so as to enable separation of the laminate at the interface between the release layer (208) and the substrate (202) upon application of a peeling force to the support (212).

## Patentansprüche

1. Ein Laminatkörper, umfassend:
einen Träger (112);
eine lichthärtbare Acrylklebstoffzusammensetzungs-Trennschicht (106), die auf und in Kontakt mit dem Träger (112) angeordnet ist;
eine lichthärtbare Acrylklebstoffzusammensetzungs-Verbindungsschicht (108), die auf und in Kontakt mit der Trennschicht (106) angeordnet ist, wobei die lichthärtbare Acrylklebstoffzusammensetzung der Verbindungsschicht (108) die gleiche ist wie die der Trennschicht (106); und
ein Substrat (102), das auf und in Kontakt mit der Verbindungsschicht (108) angeordnet ist,
wobei die Trennschicht (106) eine Menge eines Haftungsmodifizierungsmittels einschließt; wobei die Verbindungsschicht (108) eine Menge eines Haftungsmodifizierungsmittels einschließt; und
wobei die Menge von Haftungsmodifizierungsmittel in der Trennschicht (106) größer als die Menge von Haftungsmodifizierungsmittel in der Verbindungsschicht (108) ist, um eine Trennung des Laminats an der Grenzfläche zwischen der Trennschicht (106) und dem Träger (112) bei Anwendung einer Schälkraft auf den Träger (112) zu ermöglichen.

2. Ein Laminatkörper nach Anspruch 1, wobei die Trennschicht ein Polymer umfasst, das durch Polymerisation mindestens eines Monomers mit radikalischen reaktiven Gruppen hergestellt ist.

3. Ein Laminatkörper nach Anspruch 1, wobei die Menge von Haftungsmodifizierungsmittel in der Trennschicht in einer Menge von mehr als 0 bis weniger als ungefähr 6,0 Gewichtsprozent, bezogen auf das Gesamtgewicht der Trennschicht, vorhanden ist.

4. Ein Laminatkörper, umfassend:
einen Träger (212);
eine lichthärtbare Acrylklebstoffzusammensetzungs-Verbindungsschicht (206), die auf und in Kontakt mit dem Träger (212) angeordnet ist;
eine lichthärtbare Acrylklebstoffzusammensetzungs-Trennschicht (208), die auf und in Kontakt mit der Verbindungsschicht (206) angeordnet ist; und
ein Substrat (202), das in Kontakt mit der Trennschicht (208) ist,
wobei die Trennschicht (208) eine Menge eines Haftungsmodifizierungsmittels umfasst;
wobei die Verbindungsschicht (206) eine Menge eines Haftungsmodifizierungsmittels einschließt; und
wobei die Menge von Haftungsmodifizierungsmittel in der Trennschicht (208) größer als die Menge von Haftungsmodifizierungsmittel in der Verbindungsschicht (206) ist, um eine Trennung des Laminats an der Grenzfläche zwischen der Trennschicht (208) und dem Substrat (202) bei Anwendung einer Schälkraft auf den Träger (212) zu ermöglichen.

5. Ein Laminatkörper nach Anspruch 1 oder 4, wobei das Haftungsmodifizierungsmittel der Trennschicht ein Silikon(meth)acrylat in einer Menge von bis zu 2,0 Gew.-%, bezogen auf das Gesamtgewicht der Trennschicht, umfasst.

6. Ein Verfahren zum Herstellen eines Laminatkörpers, umfassend:
Auftragen einer lichthärtbaren Acrylklebstoffzusammensetzungs-Verbindungsschicht (108) auf ein Substrat (102), so dass sie in Kontakt mit dem Substrat (102) ist;
Auftragen einer lichthärtbaren Acrylklebstoffzusammensetzungs-Trennschicht (106) auf einen Träger (112), so dass sie in Kontakt mit dem Träger (112) ist,
wobei die lichthärtbare Acrylklebstoffzusammensetzung der Verbindungsschicht (108) die gleiche ist wie die der Trennschicht (106); und
Laminieren des Substrats (102), das mit der Verbindungsschicht (108) beschichtet ist, an den Träger (112), der mit der Trennschicht (106) beschichtet ist,
wobei die Trennschicht (106) eine Menge eines Haftungsmodifizierungsmittels einschließt;
wobei die Verbindungsschicht (108) eine Menge eines Haftungsmodifizierungsmittels einschließt; und
wobei die Menge von Haftungsmodifizierungsmittel in der Trennschicht (106) größer als die Menge von Haftungsmodifizierungsmittel in der Verbindungsschicht (108) ist, um eine Trennung des Laminats an der Grenzfläche zwischen der Trennschicht (106) und dem Träger (112) bei Anwendung einer Schälkraft auf den Träger (112) zu ermöglichen.

7. Ein Laminatkörper nach Anspruch 1 oder 4, oder ein Verfahren zum Herstellen eines Laminatkörpers nach Anspruch 6, wobei das Haftungsmodifizierungsmittel der Trennschicht und der Verbindungsschicht ein Silikon(meth)acrylat umfasst.

8. Ein Verfahren zum Herstellen eines Laminatkörpers nach Anspruch 6, wobei das Verfahren unter Vakuum durchgeführt wird.

9. Ein Verfahren zum Herstellen eines Laminatkörpers, umfassend:
Auftragen einer lichthärtbaren Acrylklebstoffzusammensetzungs-Trennschicht (208) auf ein Substrat (202), so dass sie in Kontakt mit dem Substrat (202) ist;
Auftragen einer lichthärtbaren Acrylklebstoffzusammensetzungs-Verbindungsschicht (206) auf eine Trennschicht (208) auf dem Substrat (202), so dass sie in Kontakt mit der Trennschicht (208) ist;
Laminieren des Substrats (202), das mit der Trennschicht (208) und der Verbindungsschicht (206) beschichtet ist, an den Träger (212),
wobei die Trennschicht (208) eine Menge eines Haftungsmodifizierungsmittels einschließt;
wobei die Verbindungsschicht (206) eine Menge eines Haftungsmodifizierungsmittels einschließt; und
wobei die Menge von Haftungsmodifizierungsmittel in der Trennschicht (208) größer als die Menge von Haftungsmodifizierungsmittel in der Verbindungsschicht (206) ist, um eine Trennung des Laminats an der Grenzfläche zwischen der Trennschicht (208) und dem Substrat (202) bei Anwendung einer Schälkraft auf den Träger (212) zu ermöglichen.

## Revendications

1. Corps stratifié comprenant :
un support (112) ;
une couche anti-adhésive à composition adhésive acrylique photodurcissable (106) disposée sur et en contact avec le support (112) ;
une couche de raccordement à composition adhésive acrylique photodurcissable (108) disposée sur et en contact avec la couche anti-adhésive (106), la composition adhésive acrylique photodurcissable de la couche de raccordement (108) étant la même que celle de la couche anti-adhésive (106) ; et
un substrat (102) disposé sur et en contact avec la couche de raccordement (108),
dans lequel la couche anti-adhésive (106) inclut une quantité d'un agent modifiant l'adhérence ; dans lequel la couche de raccordement (108) inclut une quantité d'un agent modifiant l'adhérence ; et
dans lequel la quantité d'agent modifiant l'adhérence dans la couche anti-adhésive (106) est supérieure à la quantité d'agent modifiant l'adhérence dans la couche de raccordement (108), de façon à permettre une séparation du stratifié au niveau de l'interface entre la couche anti-adhésive (106) et le support (112) lors de l'application d'une force de pelage au support (112).

2. Corps stratifié selon la revendication 1, dans lequel la couche anti-adhésive comprend un polymère fabriqué à partir de la polymérisation d'au moins un monomère ayant des groupes réactifs par voie radicalaire.

3. Corps stratifié selon la revendication 1, dans lequel la quantité d'agent modifiant l'adhérence est présente dans la couche anti-adhésive en une quantité allant de plus de 0 à moins d'environ 6,0 pour cent en poids sur la base du poids total de la couche anti-adhésive.

4. Corps stratifié comprenant :
un support (212) ;
une couche de raccordement à composition adhésive acrylique photodurcissable (206) disposée sur et en contact avec le support (212) ;
une couche anti-adhésive à composition adhésive acrylique photodurcissable (208) disposée sur et en contact avec la couche de raccordement (206) ; et
un substrat (202) en contact avec la couche anti-adhésive (208),
dans lequel la couche anti-adhésive (208) comprend une quantité d'un agent modifiant l'adhérence ;
dans lequel la couche de raccordement (206) inclut une quantité d'un agent modifiant l'adhérence ; et
dans lequel la quantité d'agent modifiant l'adhérence dans la couche anti-adhésive (208) est supérieure à la quantité d'agent modifiant l'adhérence dans la couche de raccordement (206), de façon à permettre une séparation du stratifié au niveau de l'interface entre la couche anti-adhésive (208) et le substrat (202) lors de l'application d'une force de pelage au support (212).

5. Corps stratifié selon la revendication 1 ou 4 dans lequel l'agent modifiant l'adhérence de la couche anti-adhésive comprend un (méth)acrylate de silicone en une quantité allant jusqu'à 2,0 % en poids, sur la base du poids total de la couche anti-adhésive.

6. Procédé de fabrication d'un corps stratifié comprenant :
le revêtement d'une couche de raccordement à composition adhésive acrylique photodurcissable (108) sur un substrat (102) de façon à être en contact avec le substrat (102) ;
le revêtement d'une couche anti-adhésive à composition adhésive acrylique photodurcissable (106) sur un support (112) de façon à être en contact avec le support (112),
dans lequel la composition adhésive acrylique photodurcissable de la couche de raccordement (108) est identique à celle de la couche anti-adhésive (106) ; et
la stratification du substrat (102) revêtu avec la couche de raccordement (108) au support (112) revêtu avec la couche anti-adhésive (106),
dans lequel la couche anti-adhésive (106) inclut une quantité d'un agent modifiant l'adhérence ;
dans lequel la couche de raccordement (108) inclut une quantité d'un agent modifiant l'adhérence ; et
dans lequel la quantité d'agent modifiant l'adhérence dans la couche anti-adhésive (106) est supérieure à la quantité d'agent modifiant l'adhérence dans la couche de raccordement (108), de façon à permettre une séparation du stratifié au niveau de l'interface entre la couche anti-adhésive (106) et le support (112) lors de l'application d'une force de pelage au support (112).

7. Corps stratifié selon la revendication 1 ou 4, ou procédé de fabrication d'un corps stratifié selon la revendication 6, dans lequel l'agent modifiant l'adhérence de la couche anti-adhésive et de la couche de raccordement comprend un (méth)acrylate de silicone.

8. Procédé de fabrication d'un corps stratifié selon la revendication 6, dans lequel le procédé est mis en oeuvre sous vide.

9. Procédé de fabrication d'un corps stratifié comprenant :
le revêtement d'une couche anti-adhésive à composition adhésive acrylique photodurcissable (208) sur un substrat (202) de façon à être en contact avec le substrat (202) ;
le revêtement d'une couche de raccordement à composition adhésive acrylique photodurcissable (206) sur la couche anti-adhésive (208) sur le substrat (202) de façon à être en contact avec la couche anti-adhésive (208) ;
la stratification du substrat (202) revêtu avec la couche anti-adhésive (208) et la couche de raccordement (206) au support (212),
dans lequel la couche anti-adhésive (208) inclut une quantité d'un agent modifiant l'adhérence ;
dans lequel la couche de raccordement (206) inclut une quantité d'un agent modifiant l'adhérence ; et
dans lequel la quantité d'agent modifiant l'adhérence dans la couche anti-adhésive (208) est supérieure à la quantité d'agent modifiant l'adhérence dans la couche de raccordement (206), de façon à permettre une séparation du stratifié au niveau de l'interface entre la couche anti-adhésive (208) et le substrat (202) lors de l'application d'une force de pelage au support (212).
